# EUROPÄISCHE PATENTANMELDUNG

(11) **EP 1 686 405 A1**
(43) Veröffentlichungstag der Anmeldung: **02.08.2006**
(21) Anmeldenummer: 06003699.3
(22) Anmeldetag: 23.10.1999
(51) Int. Cl.: G02B 13/24

(54) **Mikrolithographisches Reduktionsobjektiv mit fünf Linsengruppen**

(30) Priorität: 30.11.1998 DE 19855108
(62) Teilanmeldung aus: 99121205.1
(71) Anmelder: Carl Zeiss SMT AG, 73447 Oberkochen (DE)
(72) Erfinder: Schuster, Karl Heinz, 89551 Königsbronn (DE); Beierl, Helmut, 89522 Heidenheim (DE); Ulrich, Wilhelm, 73434 Aalen (DE); Herkommer, Alois, 73431 Aalen (DE); Klem, Gregor, 90449 Nürnberg (DE); Fürter, Gerhard, 73479 Ellwangen (DE)
(74) Vertreter: Schultz, Jörg Martin

(57) **Zusammenfassung**

Mikrolithographisches Projektionsobjektiv mit einer Linsenanordnung, bestehend aus
einer ersten Linsengruppe (LG1) positiver Brechkraft,
zweiten Linsengruppe (LG2) negativer Brechkraft,
dritten Linsengruppe (LG3) negativer Brechkraft,
vierten Linsengruppe (LG4) negativer Brechkraft und
fünften Linsengruppe (LG5) positiver Brechkraft
wobei
die Systemblende (AS) in der fünften Linsengruppe (LG5) liegt und mindestens zwei Linsen dieser Linsengruppe (LG5) vor der Systemblende (AS) liegen. Dabei ist vorgesehen, daß die bildseitige numerische Apertur größer als 0,65 ist (in Beispielen bis 0,8), oder daß diese Linsengruppe (LG5) mindestens 13 Linsen (L18 - L31) aufweist, oder daß die Systemblende (AS) im Bereich der Linse (L22), an der das Lichtbündel den größten Durchmesser annimmt, und ihrer beiden benachbarten Linsen (L21, L23) angeordnet ist.

## Beschreibung

Das gattungsgemäße mikrolithographische Reduktionsobjektiv nach dem Oberbegriff des Anspruch 1 ist ein rein refraktives Hochleistungsobjektiv, wie es für die hochauflösende Mikrolithographie besonders im DUV-Wellenlängenbereich benötigt wird.

Derartige refraktive Objektive mit zwei Strahltaillen sind schon in dem Artikel von E. Glatzel "New lenses for microlithography" SPIE, Vol. 237, 310 (1980) beschrieben und seitdem ständig weiterentwickelt worden. Gattungsgemäße Objektive der Firma Carl Zeiss werden in Wafer-Steppern und Wafer-Scannern PAS der Firma ASML, Niederlande, verkauft.

Ein derartiges Objektiv der Firma Tropel aus dem Jahre 1991 ist in Figur 16 von J.H. Bruning "Optical Lithography - Thirty years and three orders of magnitude" SPIE, Vol 3049, 14-27 (1997) gezeigt. Zahlreiche Varianten gattungsgemäßer Projektionsobjektive finden sich in Patentanmeldungen, so EP 0 712 019-A (US Ser. 337 647 v. 10. Nov. 1994), EP 0 717 299-A, EP 0 721 150-A, EP 0 732 605-A, EP 0 770 895-A, EP 0 803 755-A (US 5,781,278), EP 0 828 172-A.

Ähnliche Objektive mit noch etwas kleinerer numerischer Apertur finden sich auch in SU 1 659 955-A, EP 0 742 492-A (Fig. 3) US 5,105,075 (Fig. 2 und 4), US 5,260,832 (Fig. 9) und DD 299 017-A.

Aufgabe der Erfindung ist es, einen Objektivtyp anzugeben, der im Umfeld des bekannten Stands der Technik durch hohe Auflösung bei großem Bildfeld und kleiner Baulänge hervorragt und dessen Bildfehlerkorrektur, besonders hinsichtlich der Verzeichnung, auch mit verschiedenen Beleuchtungsarten (verschiedener Kohärenzgrad usw.) und bei deutlichem Abblenden (für Belichtungen mit größerem Schärfentiefenbereich) stabil bleibt.

Die Lösung der Aufgabe gelingt mit einem Objektiv nach einem der Ansprüche 1, 2 und 11.

Die Blende wird in die fünfte Linsengruppe im Bereich des dritten Bauchs des Lichtbündels verlegt. Insgesamt erhält diese fünfte Linsengruppe und die Einbindung der Systemblende mehr Bedeutung. Die beim Stand der Technik teilweise der Ausbildung der Taillen, speziell der ersten, gewidmete Aufmerksamkeit wird dann weitgehend bedeutungslos, wie die Ausführungsbeispiele zeigen.

Die hohe numerische Apertur als primäres Mittel zur Erzielung hoher Auflösung strapaziert das Design im wesentlichen zwischen Systemblende und Bildebene, besonders wenn Baulänge und Linsendurchmesser einigermaßen klein bleiben sollen, was insbesondere für eine leichte Integration in vorhandene Konzepte von Projektionsbelichtungsanlagen und für die Fertigung, sowie auch aus Kostengründen stark bevorzugt wird.

Demgemäß geben die Unteransprüche 3 bis 9 und 12 vorteilhafte Ausführungsformen der fünften Linsengruppe an.

Unteranspruch 10 betrifft die besonders vorteilhafte Abblendbarkeit des Objektivs, die durch jeweils einzelne Minimierung der verschiedenen Bildfehler erreicht wird. Dies wird wiederum mit dem Designkonzept der Erfindung ermöglicht. Anders als bei einem Objektiv mit fester Apertur können nicht verschiedene große Fehler subtraktiv ausgemittelt werden. Der Vorteil ist, daß der Anwender das trade-off von Auflösung und Schärfentiefe jeweils bezogen auf den Anwendungsfall optimieren kann.

Weitere vorteilhafte Ausführungsformen sind Gegenstand der Unteransprüche 13 bis 16. Eine Projektionsbelichtungsanlage nach den Ansprüchen 17 oder18 ergibt die optimale Anwendung dieser Objektive und zeichnet sich durch große Anwendungsbreite aus. Besondere Bedeutung hat die nach Anspruch 18 erreichte große Toleranz der Abbildungsleistung gegen Änderungen des Beleuchtungssettings.

Das Herstellverfahren nach Anspruch 19 macht von der hervorragenden Korrektur des Objektivs durch flexible Beleuchtungs- und Apertureinstellung bei verschiedenen im Herstellprozess aufeinanderfolgenden Belichtungen Gebrauch. Die einzelnen Belichtungen können dabei auf einer Projektionsbelichtungsanlage mit verschiedenen Masken erfolgen, oder es können mehrere erfindungsgemäße Projektionsbelichtungsanlagen - auch in Kombination mit anderen - in einer Fertigungslinie genutzt werden.

Näher erläutert wird die Erfindung anhand der Zeichnung.

Dabei zeigen:
- Figur 1: den Linsenschnitt eines ersten Ausführungsbeispiels;
- Figur 2: den Linsenschnitt eines zweiten Ausführungsbeispiels;
- Figur 3: den Linsenschnitt eines dritten Ausführungsbeispiels;
- Figur 4a-c: die Queraberrationen im Sagittalschnitt für verschiedene Bildhöhen zu Figur 1;
- Figur 5a-c: die Queraberrationen im Meridionalschnitt für verschiedene Bildhöhen zu Figur 1;
- Figur 6: den Linsenschnitt eines vierten Ausführungsbeispiels; und
- Figur 7: schematisch ein Beispiel einer erfindungsgemäßen Proj ektionsbelichtungsanlage.

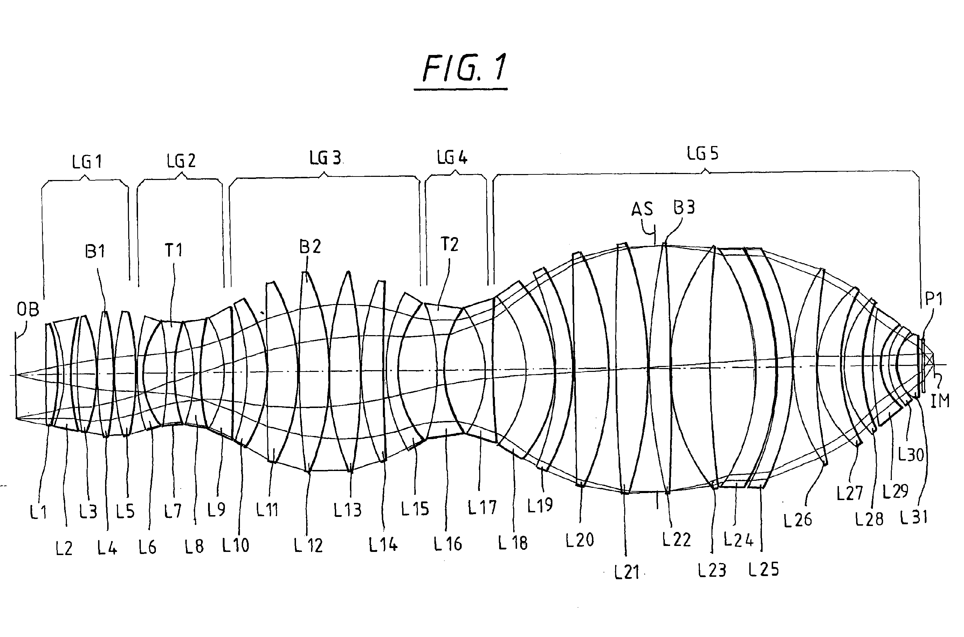

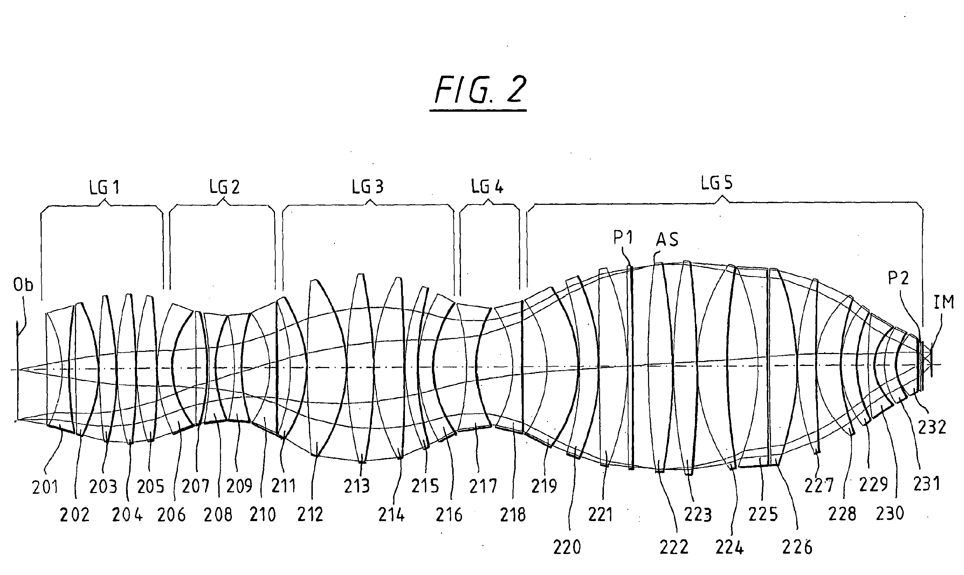

Entsprechend dem primären Bedarf für ein erfindungsgemäßes Projektionsobjektiv sind die Beispiele der Figuren 1 bis 3 und 6 für den Betrieb mit einem in der DUV-Mikrolithographie üblichen Excimer-Laser von 248, 38 nm Wellenlänge ausgelegt und enthalten ausschließlich Quarzglas-Linsen. Ihre Schnittweite liegt mit 1000 mm für Figuren 2, 3 und 6 bis 1150 mm bei Figur 1 am unteren Ende des Gebräuchlichen und des Machbaren. Die numerische Apertur von 0,70 (bei den Figuren 2, 3 und 6) und 0,80 bei Figur 1 liegt deutlich über dem vorbekannten, zeigt die Potenz des erfindungsgemäßen Designs und erlaubt die Ausführung der Mikrolithographie mit Auflösungen bis herunter zu 0,18 µm und weniger unter Serien-Produktionsbedingungen. Solche Auflösungen galten noch vor kurzem als überhaupt nicht mit der optischen Lithographie zugänglich.

Mit einer Bildhöhe 2Y_{B} = 27,2 mm ergibt sich so bei NA = 0,70 der sehr hohe Lichtleitwert von LLW = NA · 2 Y_{B} = 19,04. Das Objektiv ist damit für einen Scanner mit einem 8 x 26 mm² Bildfeld geeignet.

Beachtlich ist dabei, daß die Steigerung der bildseitigen numerischen Apertur von 0,63 schon zu dem erreichten Wert von 0,70 (Fig. 2, 3, 6) wesentlich schwieriger ist als etwa die Steigerung von 0,45 zu 0,6, da bekanntlich bei NA = 1,0 in Luft alle Bildfehler einen Pol erreichen und entsprechend bei Annäherung an diesen Wert immer stärker ansteigen bzw. immer schwerer zu korrigieren sind. Das Beispiel der Figur 1 zeigt also mit NA = 0,8 eine hervorragende Konstruktion.

Die Linsendaten des Ausführungsbeispiels nach Figur 1 sind in Tabelle 1 angegeben. 31 Linsen L1 bis L31 und eine Planplatte P1 sind vorgesehen. P1 dient als leicht tauschbares waferseitiges Abschlußfenster.

Der erreichte RMS-Fehler von unter 13 mλ über alle Bildhöhen zeigt eine hervorragende Abbildungsleistung.

Die Linsen L1 bis L5 bilden die erste Linsengruppe LG1 mit dem ersten Bauch B1 des Lichtbündels an der Rückfläche der Linse L4. Eine negative Linse L2 leistet die erforderliche Strahlaufweitung.

Die Linsengruppe LG2 aus den negativen Linsen L6 bis L9 bildet an der Rückfläche der Linse L7 die erste Taille T1. Typisch für diese Linsengruppe LG2 sind die zur Taille konkaven Menisken L6 und L9.

Die dritte Linsengruppe LG3 besteht aus den fünf positiven Linsen L10 bis L14, deren äußere L10 und L14 jeweils als außenseitig konkave Menisken ausgebildet sind, sowie dem negativen bildseitig konkaven Meniskus L15. An der Rückfläche der Linse L12 ist der zweite Bauch B2 mit dem örtlich maximalen Lichtbündeldurchmesser ausgebildet.

Die vierte Linsengruppe LG4 besteht aus zwei Negativlinsen L16 und L17. An der Rückfläche der Linse L16 ist die zweite Taille T2 ausgebildet. Hier ist eine starke bikonvexe Luftlinse ausgebildet.

Die fünfte Linsengruppe LG5 mit den 14 Linsen L18 bis L31 ist für das erfindungsgemäße Objektiv am bedeutendsten.

Vor der Linse L22 ist die Systemblende AS angeordnet. An der Vorderfläche der folgenden Linse L22 ist der dritte Bauch B3 mit seinem gegenüber dem Blendendurchmesser (306,3 mm) nur geringfügig größeren Lichtbündeldurchmesser (308,0 mm) ausgebildet.

Erfindungsgemäß erfolgt die Strahlumlenkung im Bereich des Bauchs B3 durch eine Mehrzahl beidseits der Blende AS angeordneter mäßig stärker und damit ziemlich dünner Positivlinsen L19 bis L23. Damit wird die sphärische Unterkorrektur in diesem Bereich minimiert und gleichzeitig die Baulänge gegenüber dem Einsatz weniger, aber starker und dicker Linsen verringert.

Auch die Variation der Bildfehler beim Abblenden oder bei verschiedenen BeleuchtungsEinstellungen wird durch diese Maßnahme verringert. Bei den beiden im divergenten Strahlengang stehenden Linsen L19 und L20 erhält letztere mehr Brechkraft. Die Linsen L21 und L22 zeigen gleichmäßig verteilte Brechkraft, der Strahlengang zwischen den beiden ist nahezu parallel. Die Linsen 21 bis 23 übernehmen einen erheblichen Teil der Systembrechkraft bei kleinstmöglicher Erzeugung von sphärischer Überkorrektur und entspannen die Problematik der Abhängigkeit der Fehlerkorrektur von numerischer Apertur und Beleuchtungsart (NA-Sigma-Problem). Somit sind hervorragende Abbildungseigenschaften bei den verschiedensten Beleuchtungseinstellungen und Apertureinstellungen erreichbar.

Die erste Linse L18 der fünften Linsengruppe LG5 ist ein schwach brechender dicker objektseitig konkaver Meniskus. Hier wäre eine Aufteilung durch eine sphärisch überkorrigierende Luftlinse zwar entspannend für die Korrektionswirkung der folgenden Linsen, würde aber die Baulänge unvorteilhaft vergrößern.

Die Linse L24 bildet mit der nur durch einen dünnen Luftspalt getrennten folgenden bikonvexen Linse L25 im wesentlichen einen schwach brechenden dicken Meniskus. Er balanciert durch sphärische Überkorrektur die entsprechende Wirkung der vorangehenden Linsen L18 bis L23. Die Aufspaltung in die zwei Teile L24 und L25 bringt hier wiederum die kürzeste Baulänge. Beide sind die einzigen Linsen bildseitig der Systemblende AS, die objektseitig konkav sind.

Der genau umgekehrte Vorzug von dicker Linse L18 und aufgespaltenem Meniskus L24, L25 erklärt sich aus den unterschiedlichen Umgebungen und Arbeitsbereichen der Menisken. L18 steht wenig belastet im divergenten Strahlengang. Alle Strahlen durchlaufen die Linsenflächen weitgehend normal. Der Meniskus L18 wirkt in erster Linie als Petzval-Element und drückt die Petzvalsumme des Objektivs. Diese Funktion kann jedoch auch umverteilt werden, so daß die Dicke reduziert sein kann.

Der aufgespaltene Meniskus L24, L25 steht im Gegensatz dazu im konvergenten Strahlengang und ist mittel bis stark belastet. Er übernimmt allein die Aufgabe der sphärischen Überkorrektur der näheren Umgebung. Bei einteiliger Ausführung bedingt dies eine beachtliche Dicke. Die Aufspaltung des Meniskus durch einen wenig belasteten Luftraum schafft die Entkopplung von Meniskenradien und Meniskendicke. Dadurch gelingt es, beide Linsen L24, L25 auf geringe Dicke zu setzen und die Gesamtdicke zu senken.

Die beiden negativen Menisken L29 und L30 mit der abschließenden Sammellinse L31 werden in der Literatur teilweise auch als sechste Linsengruppe bezeichnet.

Die Korrektur der sagittalen schiefen sphärischen Aberration bereitet bei Aperturerhöhung besondere Probleme. Durch die obengenannten Maßnahmen im Blendenbereich werden diese bereits gemildert, aber noch nicht gelöst. Im feldwirksamen Bereich zwischen Blende AS und Bild IM wird zur Korrektur der sagittalen schiefen sphärischen Aberration eine Erhöhung der Einzelbrechkräfte von Plus- (L26, L27, L28, L31) und Minuslinsen (L29, L30) vorgesehen. Das Mittel der Wahl ist damit die Korrektion durch Kompensation der Bildfehler höherer Ordnung. Allerdings ist dies auch für die relativ großen Durchmesser der Linsen L19 bis L25 im Blendenraum verantwortlich. Die Brechkraft der Negativlinse L29 ist also hoch, drei vorangestellte Positivlinsen L26 bis L28 erlauben die verteilte Bereitstellung der entsprechenden positiven Brechkraft. Durch den bei drei Linsen großen Freiraum hinsichtlich der Durchbiegung der Linsen wird es möglich, die Sinus i-Winkel der Komastrahlen hier jeweils unter dem Wert der hohen numerischen Apertur von 0,80 zu halten. Die starke Durchbiegung des negativen Meniskus L29 ergibt vor und hinter ihm sphärisch überkorrigierende Lufträume.

Die Korrektur der Bildfehler außerhalb der Hauptschnitte wird durch die gesteigerte Apertur ganz erheblich erschwert. Zu ihrer Korrektur wird die Abstimmung der Brechkräfte in der dritten Linsengruppe LG3 im Bereich des zweiten Bauchs B2 optimiert. Das Linsenpaar L14 und L15 lenkt das Strahlbündel in die zweite Taille T2 und schafft damit in platzsparender Weise ebenso wie Linse L18 einen günstigen Beitrag zur Petzvalkorrektur. Die positiven Linsen L10 bis L13 der dritten Linsengruppe LG3 und die negative Linsengruppe LG4 werden dadurch von Brechkraft entlastet.

Die positive Brechkraft von L14 verbessert die Bildfehler betrachtet im 45°-Schnitt durch die Apertur. Durch die negative Brechkraft von L15 wird die negative vierte Linsengruppe LG4 mit den sphärisch überkorrigierenden Linsen L16 und L17 entlastet, wodurch Zonenfehler in Apertur und Feld reduziert werden.

Zwei Einzellinsen L14, L15 sind hier einem dicken Meniskus klar vorzuziehen: Zum einen kann wie dargestellt die Bildfehlerkorrektur substantiell verbessert werden, zum anderen wird die Kühlung der Linsen, was bei dem schlitzförmigen Feld von Scannern und der nicht vernachlässigbaren Absorption bei hoher Strahlungsleistung ein als "lens heating" bekanntes Problem ist (besonders bei 193nm), verbessert.
Diese Merkmale sind auch bei den folgenden Ausführungsbeispielen entsprechend zu finden.

Die weiteren Ausführungsbeispiele Fig. 2 und 3 sowie 6 sind bei mäßig hoher Apertur NA = 0,7 ausgeführt. Die Schnittweiten reduzieren sich dabei auf 1000 mm.
Das zweite Ausführungsbeispiel nach Figur 2 und Tabelle 2 zeigt, daß das Design gegenüber Änderungen in den ersten beiden Linsengruppen LG1 und LG2 weitgehend stabil ist. In der ersten Linsengruppe LG1 haben die ersten beiden Linsen 201 und 202 gegenüber Figur 1 einen Platzwechsel vorgenommen. In der zweiten Linsengruppe LG2 ist eine positive Linse 207 zwischen die negativen Linsen 206 und 208 bis 210 eingeschoben. Die Ausbildung dieser Linsengruppe LG2 mit oder ohne Positivlinse wird im Stand der Technik vielfach als wichtig dargestellt, so in EP 0 770 895-A (ohne) und EP 0 717 299-A (mit).

Insbesondere die fünfte Linsengruppe zeigt die gleichen qualitativen Merkmale, durch die reduzierte Apertur sind aber die Linsendurchmesser wesentlich reduziert.

Gegenüber dem Meniskuspaar L24/L25 ist hier bei den Linsen 225, 226 der dünne Luftspalt deutlich weniger gekrümmt. Der bei L24/L25 zu Figur 1 beschriebene Haupteffekt der spärischen Überkorrektur bleibt erhalten.

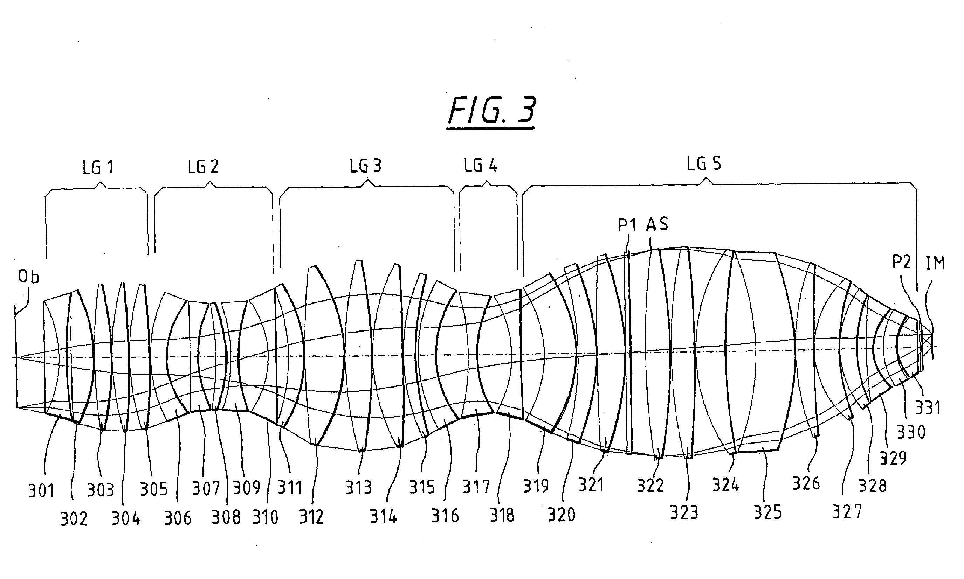

Das dritte Ausführungsbeispiel nach Figur 3 und Tabelle 3 zeigt die erste Linsengruppe wie Beispiel 2. Die zweite Linsengruppe LG2 zeigt die Positivlinse 308 nunmehr in die Mitte zwischen die je zwei Negativlinsen 306, 307 und 309, 310 gewandert.

Die fünfte Linsengruppe LG5 ist jetzt durch Zusammenfassen der Linsen L24 und L25 der Figur 1 zum dicken Meniskus 325 um eine Linse auf 13 Linsen reduziert. Mit dieser Anordnung ist ebenso wie bei einer Aufteilung des Meniskus in die zwei Linsen L24 und L25 eine gleich gute Abbildungsleistung möglich.

Bei beiden Ausführungsbeispielen nach Figuren 2 und 3 ist außer der Abschluß-Planplatte P2 noch eine blendennahe Planplatte P1 vorgesehen. Diese kann z.B. als Apodisations-Filter genutzt werden.

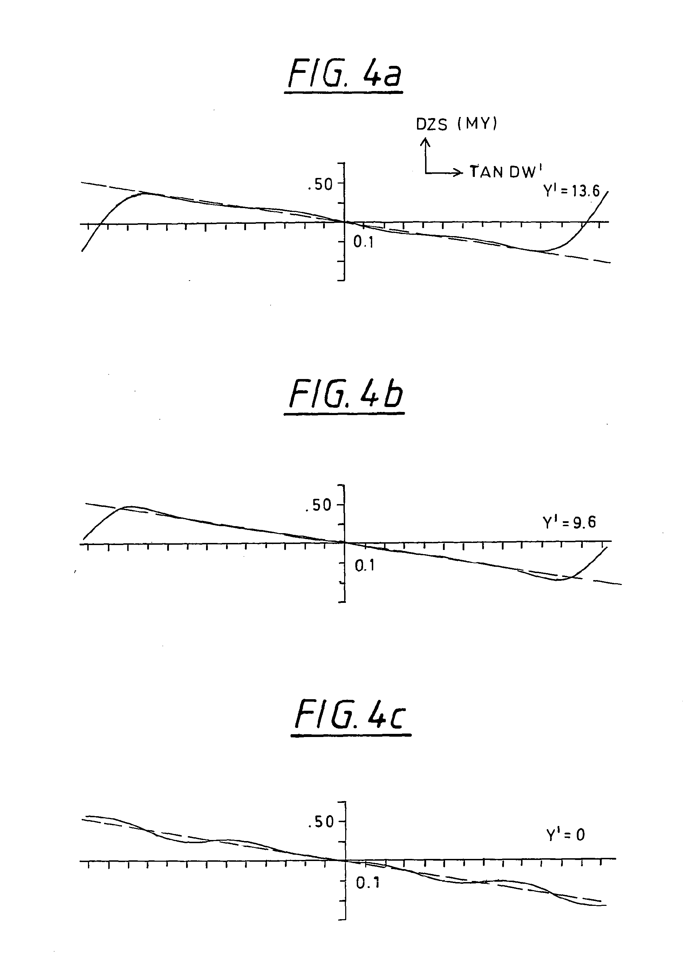

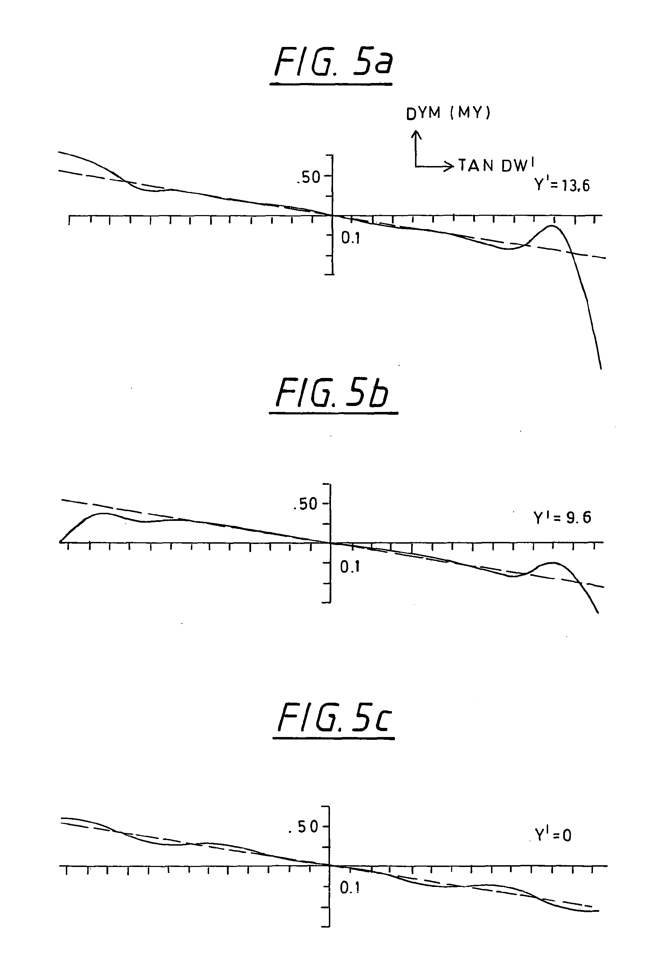

Die erreichte gute Bildfehlerkorrektur soll für das Beispiel der Figur 1 näher dargestellt werden. Figuren 4a bis 4c zeigen die sagittale Querabweichung DZS als Funktion des halben Aperturwinkels DW' für die Bildhöhen 13,6 , 9,6 und 0 mm. Figuren 5a bis 5c zeigen die entsprechenden Meridionalschnitte DYM.

In Tabelle 4 ist die Verzeichnung des Hauptstrahls Vhs für verschiedene Bildhöhen (in Bruchteilen der maximalen Bildhöhe Y' = 13,6 mm) angegeben. Sie liegt für alle Bildhöhen bei maximal 1,5 nm.

Tabelle 5 gibt die Abweichung der Verzeichnung ΔV von diesem Vhs für verschiedene Einstellungen der numerischen Apertur NA und des Kohärenzgrads Sigma. Ringaperturbeleuchtungen mit den Werten von 0,35-0,70 und 0,50-0,85 von Sigma sind ebenfalls berücksichtigt. Der Größtwert dieser Abweichung ist 4,7 nm, überwiegend liegen die Werte unter 3 nm.

Insgesamt liegt die Verzeichnung also überall und mit allen Einstellungen unter 10nm, sogar unter 6nm und überwiegend noch darunter. Dabei sind diese Werte im Zusammenhang mit der sehr hohen NA von 0,8 dieses Objektivs zu sehen. Bei kleinerer NA lassen sich erheblich kleinere Verzeichnungen realisieren..

Es zeigt sich also eine sehr gute Stabilität dieses Designs gegen Änderungen der ausgenutzten Apertur NA (abblenden) und Verändern des Beleuchtungs-Settings (Sigma).

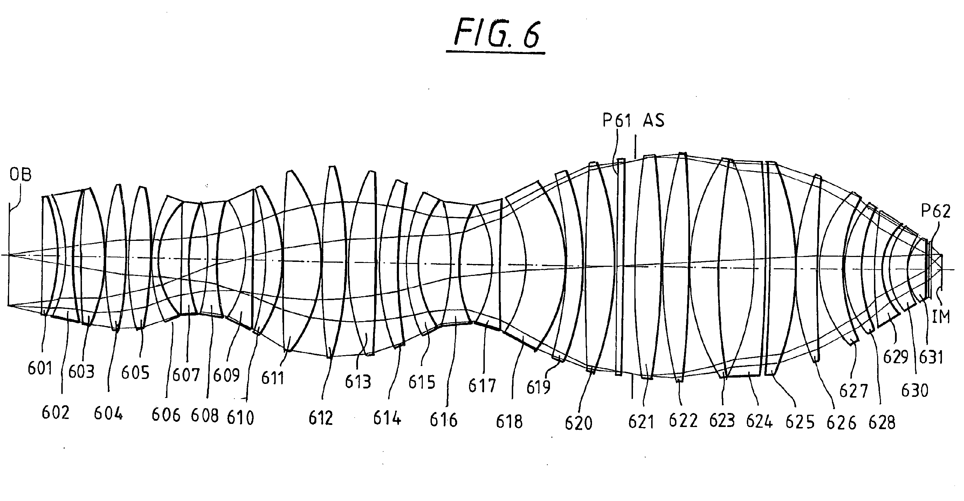

Das weitere Ausführungsbeispiel nach Figur 6 und Tabelle 6 unterscheidet sich von den vorangehenden Beispielen hauptsächlich durch eine minimierte Variation der realen Blendenlage von 25 mm auf jetzt 15 mm. Dies wurde dadurch erreicht, daß das gekrümmte Bild (Blende) der Pupille durch gezielte Korrektion des Astigmatismus im Tangentialschnit teilweise kompensiert wurde. Damit kann eine Abblendung ohne Lageänderung der Blende AS ausgeführt werden. Der Abbildungsmaßstab ist 1:4, die numerische Apertur ist NA = 0,70.

Insgesamt entspricht der Aufbau weitgehend dem Beispiel der Figur 1. Der Luftspalt zwischen den Linsen 624 und 625 ist nur wenig gekrümmt.

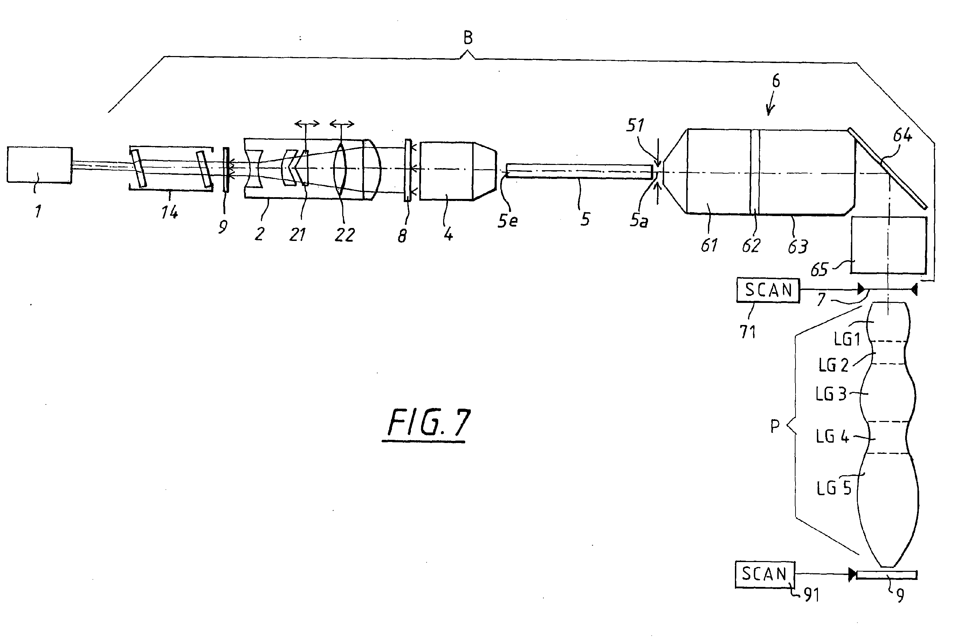

Figur 7 gibt einen Überblick über ein Beispiel einer Projektionsbelichtungsanlage mit erfindungsgemäßem Projektionsobjektiv. Ein geeignetes Beleuchtungssystem B ist beispielsweise aus EP 0 747 772-A (US Ser. No. 08/658,605) bekannt.

Der Laser 1 ist ein in der Mikrolithographie im tiefen Ultraviolett (DUV) gebräuchlicher KrF-Excimer-Laser mit 248nm Wellenlänge.

Ein Strahlaufweiter 14, z.B. eine Spiegelanordnung nach DE-A 41 24 311, dient zur Kohärenzreduktion und Vergrößerung des Strahlquerschnitts.

Ein erstes diffraktives optisches Rasterelement 9 bildet die Objektebene eines Objektivs 2, in dessen Austrittspupille ein zweites diffraktives optisches Rasterelement 8 vorgesehen ist.

Eine Einkoppeloptik 4 überträgt das Licht auf die Eintrittsfläche 5e eines Glasstabs 5, der durch mehrfache innere Reflexion das Licht mischt und homogenisiert. Unmittelbar an der Austrittsfläche 5a ist eine Zwischenfeldebene, in der ein Reticle-Masking-System (REMA) 51, eine verstellbare Feldblende, angeordnet ist. Das nachfolgende REMA-Objektiv 6, mit Linsengruppen 61, 63, 65, Umlenkspiegel 64 und Pupillenebene 62 bildet die Zwischenfeldebene des Reticle-Masking-Systems 51 auf das Reticle 7 ab.

Bei einem Wafer-Scanner wird auf dem Reticle 7 ein schmaler Streifen, ein Rechteck mit einem Aspektverhältnis von 1 : 2 bis 1 : 8, beleuchtet und durch Scannen das gesamte strukturierte Feld eines Chips seriell beleuchtet. Die Beleuchtung ist extrem gleichmäßig und randscharf (nur in Richtung senkrecht zur Scanrichtung) zu gestalten.

Die Ausführung der dem Glasstab 5 vorgelagerten Teile, insbesondere der optischen Rasterelemente 8 und 9, ist so gewählt, daß die Eintrittsöffnung 5e nicht nur möglichst homogen, sondern auch mit höchstmöglichem Wirkungsgrad, d.h. ohne wesentliche Lichtverluste neben der Eintrittsöffnung 5e, ausgeleuchtet wird.

Wie in DE 44 21 053 beschrieben, ist das Objektiv 2 ein Zoom-Objektiv (bewegliche Linse 22) mit integriertem verstellbarem Axicon-Paar 21. Die Brennweite hat einen dreifachen Dehnungsbereich, so daß partiell kohärente Beleuchtung mit üblichen Werten von ca. 0,3 ≤ σ ≤ 0,9 erzeugt werden kann.

Durch Verstellen des Axicon-Paars 21 lassen sich zudem angepaßte Ringaperturbeleuchtungen einstellen. Durch zusätzliche Blenden oder spezielle Pyramidenform des Axicon-Paars 21 lassen sich zudem Sonderformen der Beleuchtung erzeugen.

Zwischen Reticle (Maske) 7 und Wafer 9, jeweils mit Scan-Einrichtung 71, 91 und den bekannten Hilfseinrichtungen, ist das erfindungsgemäße Projektionsobjektiv P mit den Linsengruppen P 1 bis P5 angeordnet.

**Tabelle 1**

| No. | r (mm) | d (mm) | | Hₘₐₓ (mm) |
|---|---|---|---|---|
| 0b | | 20,147 | | |
| L1 | -2471,057 -247,584 | 13,126 7,640 | Quarzglas | |
| L2 | -163,307 327,943 | 10,000 7,757 | Quarzglas | |
| L3 | 662,693 -209,088 | 22,614 ,750 | Quarzglas | |
| L4 | 350,222 -416,285 | 21,378 ,750 | Quarzglas | 76,9 |
| L5 | 265,534 -413,278 | 26,426 ,750 | Quarzglas | |
| L6 | 197,069 111,439 | 10,000 26,308 | Quarzglas | |
| L7 | -583,382 166,249 | 10,000 24,524 | Quarzglas | 63,0 |
| L8 | -200,161 362,426 | 10,000 28,860 | Quarzglas | |
| L9 | -126,683 -1228,324 | 12,696 16,242 | Quarzglas | |
| L10 | -227,900 -170,208 | 23,521 ,750 | Quarzglas | |
| L11 | 47071,771 -233,889 | 38,438 ,750 | Quarzglas | |
| L12 | 987,385 -316,598 | 38,363 ,750 | Quarzglas | 123,3 |
| L13 | 332,464 -738,425 | 39,596 1,005 | Quarzglas | |
| L14 | 270,193 1414,789 | 25,935 2,982 | Quarzglas | |
| L15 | 176,884 131,204 | 18,578 47,520 | Quarzglas | |
| L16 | -248,290 146,085 | 10,000 49,811 | Quarzglas | 76,5 |
| L17 | -130,140 1307,156 | 10,000 41,204 | Quarzglas | |
| L18 | -132,994 -167,225 | 35,292 ,813 | Quarzglas | |
| L19 | -328,933 -237,606 | 24,010 ,864 | Quarzglas | |
| L20 | 17258,370 -329,484 | 43,549 9,091 | Quarzglas | |
| L21 | 2237,627 -473,604 | 40,932 10,000 | Quarzglas | |
| AS | | ,750 | | 153,1 |
| L22 | 632,745 -3192,952 | 28,431 ,750 | Quarzglas | 154,9 |
| L23 | 259,148 1097,996 | 45,432 57,012 | Quarzglas | |
| L24 | -268,055 -312,384 | 24,571 ,902 | Quarzglas | |
| L25 | -334,579 -288,740 | 23,847 ,750 | Quarzglas | |
| L26 | 226,326 547,657 | 28,117 ,750 | Quarzglas | |
| L27 | 122,960 225,966 | 34,861 ,750 | Quarzglas | |
| L28 | 117,965 174,068 | 21,109 13,226 | Quarzglas | |
| L29 | 348,448 | 10,000 | Quarzglas | |
| | 60,716 | 11,148 | | |
| L30 | 73,830 55,083 | 10,069 ,750 | Quarzglas | |
| L31 | 49,652 358,744 | 24,194 4,390 | Quarzglas | |
| P1 | ∞ | 2,492 | Quarzglas | |
| IM | ∞ | 13,082 | | 13,6 |

**Tabelle 2**

| No. | r (mm) | d (mm) | |
|---|---|---|---|
| 0b | | 16,403 | |
| 201 | -135,127 444,747 | 8,261 6,467 | Quarzglas |
| 202 | 2236,824 -162,634 | 25,206 ,750 | Quarzglas |
| 203 | 614,107 -359,473 | 18,869 ,767 | Quarzglas |
| 204 | 296,810 -800,016 | 20,742 ,828 | Quarzglas |
| 205 | 273,478 -784,045 | 21,990 ,753 | Quarzglas |
| 206 | 158,758 92,816 | 15,580 26,614 | Quarzglas |
| 207 | -5054,350 -272,904 | 11,927 2,399 | Quarzglas |
| 208 | -324,986 136,767 | 6,943 20,167 | Quarzglas |
| 209 | -260,466 192,638 | 7,605 30,771 | Quarzglas |
| 210 | -103,229 -2019,310 | 8,994 13,398 | Quarzglas |
| 211 | -206,341 -138,999 | 17,802 ,751 | Quarzglas |
| 212 | 958,350 -166,018 | 42,708 ,750 | Quarzglas |
| 213 | 407,944 -547,681 | 29,112 ,750 | Quarzglas |
| 214 | 202,874 -2504,913 | 32,883 1,264 | Quarzglas |
| 215 | 211,073 294,918 | 13,084 1,324 | Quarzglas |
| 216 | 159,796 111,543 | 15,645 36,908 | Quarzglas |
| 217 | -255,208 127,421 | 10,239 40,141 | Quarzglas |
| 218 | -120,165 1795,197 | 9,745 27,676 | Quarzglas |
| 219 | -127,485 -146,296 | 34,689 1,681 | Quarzglas |
| 220 | -317,078 -245,933 | 20,599 ,762 | Quarzglas |
| 221 | 3679,928 -292,519 | 30,729 ,650 | Quarzglas |
| P1 | ∞ | 5,009 | Quarzglas |
| AS | ∞ | 17,000 25,000 | |
| 222 | 801,236 -632,990 | 27,052 ,750 | Quarzglas |
| 223 | 551,359 -1150,052 | 25,021 ,751 | Quarzglas |
| 224 | 194,154 591,161 | 32,180 34,477 | Quarzglas |
| 225 | -287,051 3278,663 | 10,385 2,220 | Quarzglas |
| 226 | 3516,772 -295,907 | 30,035 ,763 | Quarzglas |
| 227 | 262,200 1177,101 | 19,612 ,822 | Quarzglas |
| 228 | 99,415 | 26,707 | Quarzglas |
| | 191,643 | ,753 | |
| 229 | 105,014 128,146 | 16,537 12,829 | Quarzglas |
| 230 | 391,872 55,094 | 7,165 10,778 | Quarzglas |
| 231 | 78,459 56,684 | 12,612 ,777 | Quarzglas |
| 232 | 46,211 632,773 | 22,360 2,119 | Quarzglas |
| P2 | ∞ | 1,935 | Quarzglas |
| IM | ∞ | | |

**Tabelle 3**

| No. | r (mm) | d (mm) | |
|---|---|---|---|
| 0b | | 16,402 | |
| 301 | -129,495 498,546 | 8,261 5,177 | Quarzglas |
| 302 | 2910,308 -156,581 | 25,398 ,050 | Quarzglas |
| 303 | 634,336 -347,330 | 18,854 ,301 | Quarzglas |
| 304 | 306,046 -737,998 | 18,385 ,348 | Quarzglas |
| 305 | 271,858 -702,302 | 21,701 ,776 | Quarzglas |
| 306 | 156,163 92,619 | 17,879 25,370 | Quarzglas |
| 307 | -2510,654 139,288 | 8,958 19,325 | Quarzglas |
| 308 | -302,813 -154,794 | 11,398 5,090 | Quarzglas |
| 309 | -167,161 178,376 | 7,960 32,638 | Quarzglas |
| 310 | -103,339 -1706,866 | 9,166 12,661 | Quarzglas |
| 311 | -202,377 -140,454 | 17,389 ,651 | Quarzglas |
| 312 | 987,948 -166,809 | 43,015 ,650 | Quarzglas |
| 313 | 410,646 -550,047 | 29,373 ,651 | Quarzglas |
| 314 | 205,772 -2521,253 | 33,049 ,6514 | Quarzglas |
| 315 | 213,410 290,632 | 13,198 2,731 | Quarzglas |
| 316 | 163,855 111,910 | 18,894 36,126 | Quarzglas |
| 317 | -254,971 125,915 | 9,329 38,073 | Quarzglas |
| 318 | -120,961 1713,294 | 9,708 25,896 | Quarzglas |
| 319 | -128,631 -148,294 | 34,802 2,087 | Quarzglas |
| 320 | -321,227 -242,281 | 19,897 ,618 | Quarzglas |
| 321 | 2663,658 -296,524 | 30,600 ,681 | Quarzglas |
| P1 | ∞ | 4,588 | Quarzglas |
| AS | ∞ | 17,000 | |
| 322 | 799,643 -634,102 | 27,212 ,705 | Quarzglas |
| 323 | 524,124 -1088,912 | 26,037 ,650 | Quarzglas |
| 324 | 194,184 593,348 | 32,260 32,929 | Quarzglas |
| 325 | -291,552 -300,355 | 42,741 ,729 | Quarzglas |
| 326 | 262,260 1149,322 | 19,800 ,701 | Quarzglas |
| 327 | 101,103 197,398 | 27,117 ,637 | Quarzglas |
| 328 | 105,683 | 17,553 | Quarzglas |
| | 131,192 | 11,164 | |
| 329 | 445,739 56,924 | 7,334 10,924 | Quarzglas |
| 330 | 78,549 56,171 | 13,969 1,161 | Quarzglas |
| 331 | 46,702 689,875 | 22,163 2,680 | Quarzglas |
| P2 | ∞ | 1,749 | Quarzglas |
| IM | ∞ | 11,991 | |

**Tabelle 4**

| Vhs (nm) | | | | |
|---|---|---|---|---|
| 1/8 | 2/8 | 4/8 | 6/8 | 1 |
| 1,1 | 1,5 | 0,1 | 0,9 | 0,7 |

**Tabelle 5**

| ΔV (nm) | | | | | | |
|---|---|---|---|---|---|---|
| NA | Sigma | 1/8 | 2/8 | 4/8 | 6/8 | 1 |
| 0,80 | 0,35 | 3,6 | 2,2 | 1,3 | 3,9 | -1,2 |
| 0,80 | 0,50 | 3,3 | 2,2 | 1,3 | 3,2 | -1,3 |
| 0,80 | 0,70 | 3,0 | 1,6 | 0,1 | 1,7 | -1,4 |
| 0,80 | 0,90 | 2,5 | 0,7 | -1,2 | 0,9 | -0,7 |
| 0,80 | 0,35-0,70 | 2,7 | 1,4 | -0,3 | 0,8 | -1,5 |
| 0,80 | 0,50-0,85 | 2,2 | 0,3 | -2,0 | -0,2 | -0,6 |
| 0,70 | 0,50 | 2,9 | 2,7 | 3,0 | 4,5 | -1,8 |
| 0,70 | 0,70 | 2,6 | 2,1 1 | 1,7 | 2,7 | -2,0 |
| 0,70 | 0,90 | 2,5 | 1,5 | 0,6 | 1,7 | -1,5 |
| 0,70 | 0,35-0,70 | 2,6 | 2,0 | 1,4 | 2,0 | -1,9 |
| 0,70 | 0,50-0,85 | 2,4 | 1,3 | -0,1 | 0,6 | -1,6 |
| 0,60 | 0,70 | 3,3 | 3,6 | 4,2 | 4,7 | -1,2 |
| 0,60 | 0,90 | 3,0 | 2,9 | 2,8 | 3,1 | -1,7 |
| 0,60 | 0,35 - 0,70 | 3,2 | 3,5 | 4,1 | 4,5 | -1,3 |
| 0,60 | 0,50 - 0,85 | 2,8 | 2,7 | 2,5 | 2,5 | -2,1 |

**Tabelle 6**

| No. | r (mm) | d (mm) | Glas |
|---|---|---|---|
| 0b | | 36,005 | |
| 601 | -1823,618 -214,169 | 15,518 10,000 | Quarzglas |
| 602 | -134,291 328,009 | 7,959 6,376 | Quarzglas |
| 603 | 783,388 -163,805 | 26,523 ,600 | Quarzglas |
| 604 | 325,109 -499,168 | 20,797 1,554 | Quarzglas |
| 605 | 224,560 -403,777 | 24,840 ,600 | Quarzglas |
| 606 | 142,336 86,765 | 9,000 23,991 | Quarzglas |
| 607 | 6387,721 148,713 | 7,700 21,860 | Quarzglas |
| 608 | -185,678 237,204 | 8,702 30,008 | Quarzglas |
| 609 | -104,297 -1975,424 | 9,327 12,221 | Quarzglas |
| 610 | -247,819 -152,409 | 17,715 ,605 | Quarzglas |
| 611 | 1278,476 -163,350 | 40,457 ,778 | Quarzglas |
| 612 | 697,475 -346,153 | 28,012 2,152 | Quarzglas |
| 613 | 232,015 -3080,194 | 28,068 Quarzglas 2,606 22 | |
| 614 | 219,153 434,184 | 21,134 9,007 | Quarzglas |
| 615 | 155,091 103,553 | 13,742 34,406 | Quarzglas |
| 616 | -207,801 131,833 | 8,900 35,789 | Quarzglas |
| 617 | -118,245 1262,191 | 9,299 27,280 | Quarzglas |
| 618 | -121,674 -151,749 | 42,860 ,825 | Quarzglas |
| 619 | -366,282 -236,249 | 20,128 ,838 | Quarzglas |
| 620 | 2355,228 -296,219 | 31,331 2,500 | Quarzglas |
| P61 | ∞ | 6,000 | Quarzglas |
| AS | ∞ | 12,554 | |
| 621 | 774,283 -782,899 | 29,041 ,671 | Quarzglas |
| 622 | 456,969 -1483,609 | 28,257 ,603 | Quarzglas |
| 623 | 227,145 658,547 | 30,951 36,122 | Quarzglas |
| 624 | -271,535 -997,381 | 15,659 4,388 | Quarzglas |
| 625 | -1479,857 -288,684 | 27,590 ,604 | Quarzglas |
| 626 | 259,988 1614,379 | 22,958 ,600 | Quarzglas |
| 627 | 105,026 205,658 | 29,360 ,600 | Quarzglas |
| 628 | 110,916 | 16,573 | Quarzglas |
| | 139,712 | 13,012 | |
| 629 | 499,538 56,675 | 8,300 9,260 | Quarzglas |
| 630 | 75,908 51,831 | 17,815 ,995 | Quarzglas |
| 631 | 43,727 499,293 | 19,096 2,954 | Quarzglas |
| P62 | ∞ | 2,000 | Quarzglas |
| Im | ∞ | 12,000 | |

## Patentansprüche

1. Mikrolithographisches Projektionsobjektiv mit einer Linsenanordnung, bestehend aus einer ersten Linsengruppe (LG1) positiver Brechkraft,
zweiten Linsengruppe (LG2) negativer Brechkraft,
dritten Linsengruppe (LG3) positiver Brechkraft,
vierten Linsengruppe (LG4) negativer Brechkraft und
fünften Linsengruppe (LG5) positiver Brechkraft
**dadurch gekennzeichnet, daß**
die bildseitige numerische Apertur größer als 0,65 ist, vorzugsweise größer als 0,68,
die Systemblende (AS) in der fünften Linsengruppe (LG5) liegt und
mindestens zwei Linsen dieser Linsengruppe (LG5) vor der Systemblende (AS) liegen.

2. Mikrolithographisches Projektionsobjektiv mit einer Linsenanordnung, bestehend aus einer ersten Linsengruppe (LG1) positiver Brechkraft, zweiten Linsengruppe (LG2) negativer Brechkraft, dritten Linsengruppe (LG3) positiver Brechkraft, vierten Linsengruppe (LG4) negativer Brechkraft und fünften Linsengruppe (LG5) positiver Brechkraft **dadurch gekennzeichnet, daß** die Systemblende in der fünften Linsengruppe (LG5) liegt, mindestens zwei Linsen (L18, L19, L20, L21) dieser Linsengruppe (LG5) vor der Systemblende (AS) liegen und diese Linsengruppe (LG5) mindestens 13 Linsen (L18 - L31) aufweist.

3. Mikrolithographisches Projektionsobjektiv nach Anspruch 1 oder 2, **dadurch gekennzeichnet, daß** die Systemblende (AS) zwischen zwei Sammellinsen (L21, L22) angeordnet ist und bildseitig mindestens eine weitere Sammellinse (L23) unmittelbar folgt.

4. Mikrolithographisches Projektionsobjektiv nach mindestens einem der Ansprüche 1 bis 3, **dadurch gekennzeichnet, daß** die erste Linse (L18) der fünften Linsengruppe (LG5) ein schwach brechender dicker objektseitig konkaver Meniskus ist.

5. Mikrolithographisches Projektionsobjektiv nach mindestens einem der Ansprüche 1 bis 4, **dadurch gekennzeichnet, daß** nach der Systemblende (AS) genau eine objektseitig konkave Linse (225, 325) folgt.

6. Mikrolithographisches Projektionsobjektiv nach Anspruch 5, **dadurch gekennzeichnet, daß** die objektseitig konkave Linse (325) ein dicker Meniskus ist.

7. Mikrolithographisches Projektionsobjektiv nach Anspruch 5, **dadurch gekennzeichnet, daß** die objektseitig konkave Linse (225) mit einem dünnen Luftspalt von einer Sammellinse (226) gefolgt wird.

8. Mikrolithographisches Projektionsobjektiv nach mindestens einem der Ansprüche 1 bis 4, **dadurch gekennzeichnet, daß** nach der Systemblende (AS) genau ein Paar objektseitig konkaver Linsen (L24, L26) folgt, welche mit einem dünnen Luftspalt voneinander getrennt sind.

9. Mikrolithographisches Projektionsobjektiv nach Anspruch 7 oder 8, **dadurch gekennzeichnet, daß** der Luftspalt objektseitig konkav ist. (Fig. 6)

10. Mikrolithographisches Projektionsobjektiv nach mindestens einem der Ansprüche 1 bis 9, **dadurch gekennzeichnet, daß** beim Abblenden bis zu 70 % der numerischen Apertur die Verzeichnung unterhalb von 10 nm, vorzugsweise unter 6 nm, bleibt.

11. Mikrolithographisches Projektionsobjektiv mit einer Linsenanordnung, bestehend aus einer ersten Linsengruppe (LG1) mit positiver Brechkraft,
einen Bauch (B1) des Lichtbündels bildend,
einer zweiten Linsengruppe (LG2) mit negativer Brechkraft,
eine Taille (T1) des Lichtbündels bildend,
einer dritten Linsengruppe (LG3) mit positiver Brechkraft,
einen zweiten Bauch (B2) des Lichtbündels bildend,
einer vierten Linsengruppe mit negativer Brechkraft,
eine zweite Taille (T2) des Lichtbündels bildend,
einer fünften Linsengruppe (LG5) mit positiver Brechkraft,
einen dritten Bauch (B3) des Lichtbündels bildend,
**dadurch gekennzeichnet, daß**
die Systemblende (AS) in der fünften Linsengruppe (LG5) angeordnet ist, und zwar im Bereich der Linse (L22), an der das Lichtbündel den größten Durchmesser annimmt, und ihrer beiden benachbarten Linsen (L21, L23).

12. Mikrolithographisches Projektionsobjektiv nach mindestens einem der Ansprüche 1 bis 11, **dadurch gekennzeichnet, daß** die Systemblende (AS) zwischen zwei Sammellinsen (L21, L22) der fünften Linsengruppe (LG5) angeordnet ist.

13. Mikrolithographisches Projektionsobjektiv nach mindestens einem der Ansprüche 1 bis 12, **dadurch gekennzeichnet, daß** die zweite Linsengruppe (LG2) mindestens zwei negative Linsen (206, 208-210) und eine positive Linse (207) enthält.

14. Mikrolithographisches Projektionsobjektiv nach mindestens einem der Ansprüche 1-13, **dadurch gekennzeichnet, daß** die erste Linse (201) objektseitig konkav ist.

15. Mikrolithographisches Projektionsobjektiv nach mindestens einem der Ansprüche 1-14,
**dadurch gekennzeichnet, daß** im Bereich der vierten Linsengruppe (LG4) genau drei Negativ-Linsen (L15-L17) rund um die zweite Taille (T2) angeordnet sind.

16. Mikrolithographisches Projektionsobjektiv nach mindestens einem der Ansprüche 1-15, **dadurch gekennzeichnet, daß** der Sinus des i-Winkels des Randstrahls (sini_{Rand}) an allen Linsen vor der letzten objektseitigen Linse (L31) kleiner als die objektseitige numerische Apertur (NA) ist (sini_{Rand} < NA).

17. Projektionsbelichtungsanlage der Mikrolithographie mit
einer Lichtquelle (1), insbesondere einem DUV-Excimer-Laser,
einem Beleuchtungssystem (B),
einem Masken-Halte- und -Justiersystem (7, 71)
einem Projektionsobjektiv (P) nach mindestens einem der Ansprüche 1-16 und
einem Objekt-Halte- und -Justier-System (9, 91).

18. Projektionsbelichtungsanlage nach Anspruch 16, **dadurch gekennzeichnet, daß** das Beleuchtungssystem (B) verschiedene Beleuchtungsarten, insbesondere mit verschiedenem Kohärenzgrad, erzeugt und das Projektionsobjektiv (P) bei den verschiedenen Beleuchtungsarten die Verzeichnung unterhalb von 10nm, vorzugsweise unterhalb von 6nm hält.

19. Herstellverfahren mikrostrukturierter Bauelemente unter Anwendung mehrerer mikrolithographischer Belichtungen mit einer Projektionsbelichtungsanlage mit den Merkmalen der Ansprüche 17 und 9, wobei bei verschiedenen Belichtungen verschiedene Beleuchtungsarten und/oder numerische Apertur eingestellt werden.
